Europäisches Patentamt

European Patent Office

Office européen des brevets

(19)

(11) Publication number : **0 564 271 A1**

(12) **EUROPEAN PATENT APPLICATION**

(21) Application number : **93302523.1**

(22) Date of filing : **31.03.93**

(51) Int. Cl.⁵ : **H03K 4/02**

(30) Priority : **02.04.92 JP 108442/92**

(43) Date of publication of application :
**06.10.93 Bulletin 93/40**

(84) Designated Contracting States :
**DE FR GB**

(71) Applicant : **SONY CORPORATION**
**6-7-35 Kitashinagawa Shinagawa-ku**
**Tokyo 141 (JP)**

(72) Inventor : **Nakajima, Fumio, c/o Patents**
**Divsion, Sony Corp.**
**6-7-35 Kitashinagawa, Shinagawa-ku**
**Tokyo 141 (JP)**

(74) Representative : **Targett, Kenneth Stanley et al**
**D. Young & Co., 21 New Fetter Lane**
**London EC4A 1DA (GB)**

(54) **Waveform generating circuit.**

(57)    A waveform generating circuit for generating
waveform signals, such as synchronization sig-
nals for television signals, is disclosed. Parallel
outputs of an N-stage shift register supplied
with first input pulse signals and parallel out-
puts of a second N-stage shift register supplied
with second input pulse signals are added to-
gether by a current addition circuit and a low-
frequency component of the addition output of
the current addition circuit is extracted by a
low-pass filter to generate a three-valued
waveform signal having desired pulse rise and
pulse decay times as determined by the number
of stages N of the shift registers and the unit
shift amount.

FIG.2

EP 0 564 271 A1

EP 0 564 271 A1

This invention relates to a waveform generating circuit and, more particularly but not exclusively, to a circuit for generating waveform signals, such as synchronization signals for TV signals.

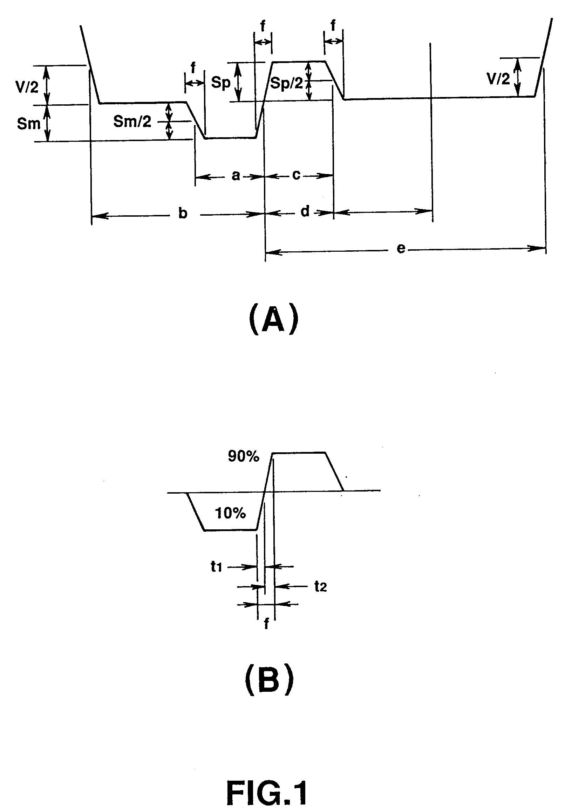

In general, studio cameras employed in broadcasting stations are in need of synchronization signals conforming to the studio standard if it is desired to output image pickup signals according to the standard television system. As for the synchronization signals for television signals, not only the frequency and the amplitude but also the pulse rise and decay times and symmetry of the pulse rising portions are prescribed. In a high definition video system (HDVS), for example, bipolarity and three-valued synchronization are adopted as the synchronization signal format. The three-valued synchronous signal having the waveform as shown in Figs.1(A) and (B) is employed, while various standard values as well as their tolerable values of deviation are prescribed, as shown in Table 1.

TABLE 1

| Sign | Name | Standard Value | Tolerable Value of Deviation |
|---|---|---|---|
| a | negative polarity pulse starting point | 0.593µs | ± 0.040µs |
| b | image signal terminating point | 1.185µs | + 0.080µs |
| | | | - 0.000µs |
| c | positive polarity pulse starting point | 0.593µs | ± 0.040µs |
| d | clamp terminating point | 1.778µs | ± 0.040µs |
| e | image signal starting point | 2.586µs | + 0.080µs |
| | | | - 0.000µs |
| f | pulse time | 0.054µs | ± 0.020µs |
| $t_1$-$t_2$ | clamp teminating point | - | ± 0.002µs |
| $s_m$ | negative pulse amplitude | 300mV | - |
| $s_p$ | positive pulse amplitude | 300mV | - |
| V | image signal amplitude | 700mV | - |
| | line frequency | 33750Hz | ± 10ppm |

Heretofore, waveform signals, such as synchronization signals, having predetermined rise times, were generated by waveform shaping with the aid of an analog waveform shaping circuit, or by reading out sampling data of desired waveform signals previously stored in a read-only memory and converting the read-out data into analog signals by a D/A converter.

Meanwhile, for generating the desired waveform signals with high precision by the conventional analog waveform shaping circuit, it is necessary to employ a filter of a higher order which has its characteristics set extremely rigorously. With the conventional analog waveform shaping circuit, synchronization signals for television signals, having prescribed values not only of frequency and amplitude but also of the pulse rise time and symmetry of the pulse rise portions, above all, bipolar three-valued synchronization signals for HDVS, can be produced with extreme difficulties if higher precision is required. Besides, the waveform generating circuit for generating desired waveform signals by a read-only memory and a D/A converter has a drawback that the circuit scale becomes larger than that for the above-mentioned analog waveform shaping circuit, while power consumption is also increased.

In accordance with the present invention, there is provided a waveform generating circuit comprising an N-stage shift register to which pulse signals are entered, N being an integer, a current addition circuit for current adding parallel output signals from said shift register, and a low-pass filter for extracting a low-frequency component of an output signal from the current addition circuit for generating an output waveform signal having a desired waveform.

With the above waveform generating circuit, parallel outputs of the N-stage shift register, to which input pulse signals are entered, are added together by a current addition circuit, and a low-frequency component of

2

the output signal of the current addition circuit is extracted to generate an output signal having a desired waveform. In this manner, the waveform signal may be generated which has the desired pulse rise and pulse decay times as determined by the number of stages N and the unit shift time of the shift registers.

The waveform shaping circuit of the invention can be a simple arrangement with low power consumption.

A specific embodiment of the present invention will now be described by way of example with reference to the accompanying drawings in which:

Fig.1 is a waveform diagram showing bipolar three-value synchronous signals in HDVS.

Fig.2 is a block circuit diagram showing a waveform generating circuit according to the present invention.

Fig.3 is a waveform diagram for illustrating the operation of the waveform generating circuit shown in Fig.2.

Referring to the drawings, a waveform generating circuit embodying the present invention is explained in detail.

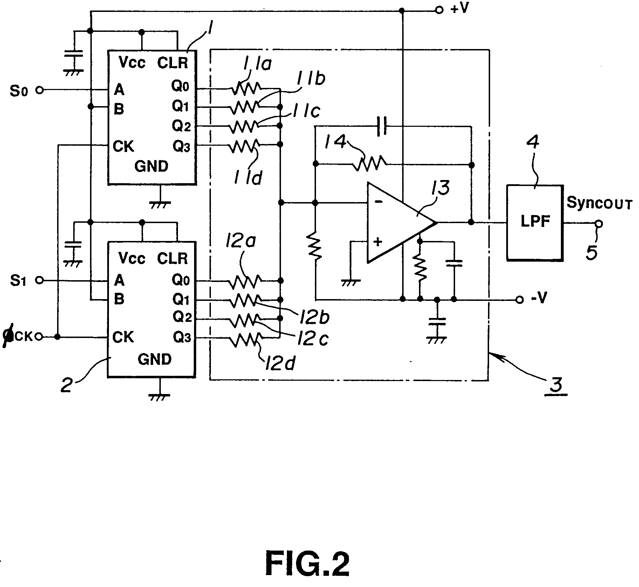

The waveform generating circuit according to the present invention is arranged as shown for example in Fig.2.

The waveform generating circuit, shown in Fig.2, is adapted for generating bipolar three-value synchronous signal for HDVS and is made up of first and second shift registers 1, 2, a current addition circuit 3 and a low-pass filter 4.

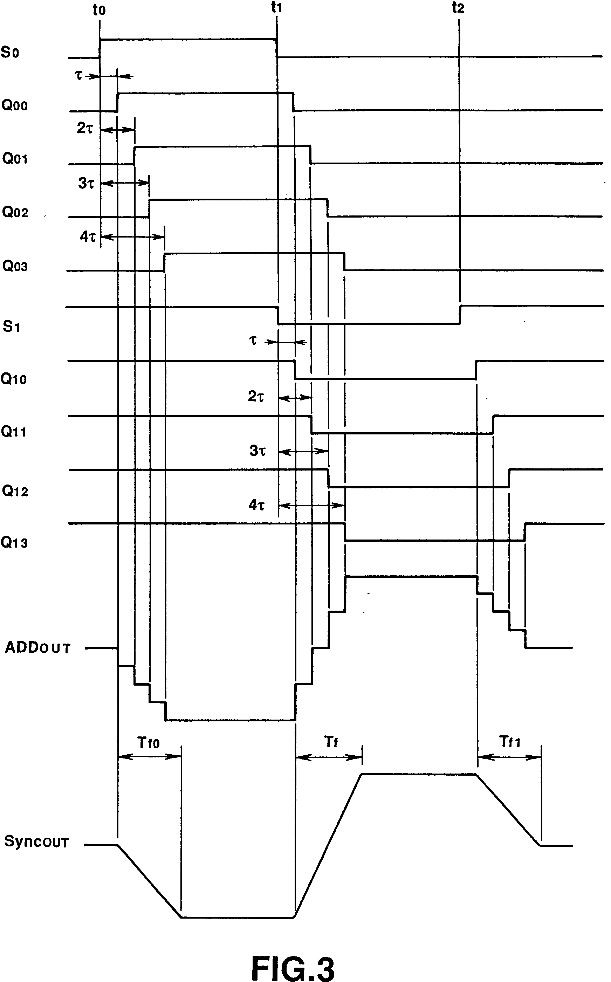

In the embodiment illustrated, a four-stage shift register is used for each of the shift registers 1, 2. The first shift register 1 is designed to generate a negative polarity waveform of the bipolar three-value synchronous signal, and a first pulse signal $S_0$, which rises at a timing $t_0$ and decays at a timing $t_1$, as shown in Fig.3, is supplied to its serial input terminal A. The second shift register 2 is designed to generate a positive polarity waveform of the bipolar three-value synchronous signal, and a second pulse signal $S_1$, which decays at a timing $t_1$ and rises at a timing $t_2$, as shown in Fig.3, is supplied to its serial input terminal A. A clock pulse $\Phi_{CK}$ of 74.25 MHz, which is a fundamental clock for HDVS, is supplied to each of clock terminals CK of the shift registers 1 and 2.

The first shift register 1 shifts the first pulse signal $S_0$ on each clock pukse $\Phi_{CK}$ to supply its parallel outputs $Q_{00}$, $Q_{01}$, $Q_{02}$, $Q_{03}$ to the current addition circuit 3. The second shift register 2 shifts the second pulse signal $S_1$ on each clock pulse $\Phi_{CK}$ to supply its parallel outputs $Q_{10}$, $Q_{11}$, $Q_{12}$, $Q_{13}$ to the current addition circuit 3.

In the embodiment illustrated, a shift quantity per stage $\tau$ for each of the first and second shift registers 1 and 2 is

$$\tau = 1/74.25 \, \text{MHz} = 13.468 \, \text{ns}$$

so that parallel outputs $Q_{00}$ to $Q_{03}$ and $Q_{10}$ to $Q_{13}$, shifted by $\tau$, $2\tau$, $3\tau$ and $4\tau$, respectively, are supplied to the current addition circuit 3, as shown in Fig.3.

The current addition circuit 3 has an operational amplifier 13, an inverting input terminal of which is supplied with the parallel outputs $Q_{00}$ to $Q_{03}$ and $Q_{10}$ to $Q_{13}$ from the shift registers 1, 2 via input resistors 11a to 11d and 12a to 12d. The operational amplifier 13 constitutes an inverting amplifier which has its non-inverting input terminal grounded and which has its non-inverting input terminal connected to the inverting input terminal via a feedback resistor 14. The operational amplifier 14 performs a current addition of the parallel outputs $Q_{00}$ to $Q_{03}$ and $Q_{10}$ to $Q_{13}$ from the shift registers 1 and 2 to generate a and $Q_{10}$ to $Q_{13}$ from the shift registers 1 and 2 to generate a step-shaped addition output $ADD_{OUT}$ as shown in Fig.3 to supply the generated step-shaped addition output to the low-pass filter 4.

The low-pass filter 4 extracts a low-frequency component of the addition output $ADD_{OUT}$ of the current addition circuit 3 to output a bipolar three-valued synchronization signal $Sync_{OUT}$ at a signal output terminal 5. That is, the low-pass filter 4 eliminates the high-frequency component contained in the step-shaped waveform components of the addition output $ADD_{OUT}$ of the low-pass filter 4 to generate the bipolar three-valued synchronization signal $Sync_{OUT}$ shown in Fig.3.

Since the pulse decay time $T_{f0}$, $T_{f1}$ and the pulse rise time $T_f$ of the bipolar three-valued synchronization signal $Sync_{OUT}$ produced at the signal output terminal 5 are determined by the number of stages N, N being herein equal to 4, and the unit shift time, that is the shift time per stage $\tau$, of the first and second shift registers 1 and 2, and

$$T_{f0} = T_f = T_{f1} = 13.468 \, \text{ns} \times 4 = 53.872 \, \text{ns}$$

thus satisfying the requirement for the pulse rise time $f$ of the bipolar three-valued synchronization signal for HDVS of 54 ns $\pm$ 20 ns. On the other hand, by selecting the number of stages and the unit shift time $\tau$ of the first shift register 1 to be equal to the number of stages and the unit shifting time $\tau$ of the second shift register 2, the requirement for symmetry of the pulse decay portions may also be satisfied.

Since the pulse decay time $T_{f0}$, $T_{f1}$ and the pulse rise time $T_f$ of the bipolar three-valued synchronization signal $Sync_{OUT}$ are determined in this manner solely by the first and second shift registers 1, 2, it is unnecessary to set filter characteristics of the low-pass filter 4 strictly. That is, it suffices if the low-pass filter 4 has the characteristics of eliminating high-frequency components contained in the step-shaped addition output waveform components from the current addition circuit 3 and hence a low-pass filter of a simple circuit design may be employed.

It is possible with the above-described waveform generating circuit to generate the bipolar three-valued synchronization signal conforming to HDVS as well as to reduce the circuit scale and power consumption as compared to a conventional waveform generating circuit adapted for generating desired waveform by a read-only memory and a D/A converter.

Although the bipolar three-valued synchronization signal conforming to a high-definition studio standards is to be generated by the waveform generating circuit described above, it is to be noted that the present invention is not limited to the above-described embodiment. For example, a bipolar three-valued waveform signal having a desired pulse rise time or pulse decay time as defined by the number of stages N and the unit shift time $\tau$ of the shift registers 1 and 2 may also be generated.

Besides, only one shift register may be employed for generating a two-valued waveform signal. That is, if the parallel outputs of the N-stage shift register to which pulse signals are entered are added together by a current addition circuit and the low-frequency component of the addition output of the current addition circuit is eliminated by a low-pass filter, a waveform signal may be generated which has desired pulse rise time and pulse decay time as determined by the number of stages N and the unit shift time of the shift register.

## Claims

1. A waveform generating circuit comprising an N-stage shift register to which pulse signals are entered, N being an integer, a current addition circuit for current adding parallel output signals from said shift register, and a low-pass filter for extracting a low-frequency component of an output signal from said current addition circuit for generating an output waveform signal.

2. The waveform generating circuit as claimed in claim 1 wherein said N-stage shift register is arranged for according the same amount of shift to the input pulse signals.

3. A waveform generating circuit comprising an M-stage shift register to which first pulse signals are entered, M being an integer, an N-stage shift register to which second pulse signals are entered, N being an integer, a current addition circuit for current adding parallel output signals from said first and second shift registers, and a low-pass filter for extracting a low-frequency component of an output signal from said current addition circuit for generating an output waveform signal.

4. The waveform generating circuit as claimed in claim 3 wherein said M-stage shift register and said N-stage shift register is arranged for according the same amount of shift to the input pulse signals.

5. The waveform generating circuit as claimed in claim 4 wherein M is equal to N.

6. The waveform generating circuit as claimed in claim 5 wherein the output signal of said low-pass filter is a three-valued synchronization signal for HDVS.

**(A)**

**(B)**

## FIG.1

FIG.2

**FIG.3**

European Patent

Office

**EUROPEAN SEARCH REPORT**

Application Number

EP    93 30 2523

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | PATENT ABSTRACTS OF JAPAN vol. 3, no. 139 (E-152)17 November 1979 & JP-A-54 117 670 ( RICOH K.K. ) 9 December 1979 * abstract * | 1,2 | H03K4/02 |
| A | US-A-4 816 830 (COOPER) * column 2, line 22 - column 6, line 52; figures * | 1-5 | |
| A | EP-A-0 265 637 (SIEMENS AG) * column 7, line 11 - column 23, line 14; figures 2,3,6-15 * | 1 | |
| | | | **TECHNICAL FIELDS SEARCHED (Int. Cl.5)** |
| | | | H03K G06G |

The present search report has been drawn up for all claims

| Place of search | Date of completion of the search | Examiner |
|---|---|---|
| BERLIN | 05 JULY 1993 | TAYLOR P. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)